# EUROPÄISCHE PATENTSCHRIFT

(11) **EP 0 848 882 B1**
(45) Veröffentlichungstag und Bekanntmachung des Hinweises auf die Patenterteilung: **09.06.1999**
(21) Anmeldenummer: 96931005.1
(22) Anmeldetag: 03.09.1996
(51) Int. Cl.: H04N 3/15

(54) **LICHTERFASSUNGSEINRICHTUNG MIT PROGRAMMIERBAREM OFFSET-STROM**
LIGHT-DETECTION SYSTEM WITH PROGRAMMABLE OFFSET CURRENT
DISPOSITIF DE DETECTION DE LUMIERE A COURANT DE DECALAGE PROGRAMMABLE

(30) Priorität: 07.09.1995 DE 19533061
(43) Veröffentlichungstag der Anmeldung: 24.06.1998
(73) Patentinhaber: Leica Geosystems AG, 9435 Heerbrugg (CH)
(72) Erfinder: SEITZ, Peter, CH-8700 Küsnacht (CH); VIETZE, Oliver, CH-8048 Zürich (CH)
(74) Vertreter: Stamer, Harald, Dipl.-Phys.
(86) Internationale Anmeldenummer: EP9603851
(87) Internationale Veröffentlichungsnummer: WO9709819

(56) Entgegenhaltungen:
- US-A- 4 839 735
- US-A- 5 241 575
- US-A- 5 336 936
- US-A- 5 376 813

## Beschreibung

Die Erfindung betrifft eine photoelektrische Halbleiter-Lichterfassungseinrichtung mit hoher Dynamik durch programmierbares Offset-Signal gemäß dem Oberbegriff des Anspruches 1.

Ein bekanntes Verfahren, die Empfindlichkeit von photoelektrischen Halbleiter-Lichterfassungseinrichtungen insgesamt, das heißt für alle Bildpunkte gleichzeitig, zu verringern, ist der sogenannte elektronische Verschluß, wie er beispielhaft beschrieben ist von H. Akimoto, H. Ono, M. Nakai, A. Sato, T. Sakai, M. Maki, M. Hikiba und H. Ando in "Lateral overflow-gate shutter for CCD image sensors", Proc. SPIE, Bd. 1656, S. 550-557 (1992). Dabei wird ein elektronischer Schalter nur während eines Bruchteils der Integrationszeit. das heißt während der sogenannten Belichtungszeit, für die Integration der durch Photonen erzeugten Ladungsträger geöffnet. Damit kann die Empfindlichkeit aller Bildpunkte gleichzeitig um den Faktor Integrationszeit/Belichtungszeit verringert werden.

Ein Verfahren, das ermöglicht, diese Ein-Aus-Schalttechnik für die einzelnen Bildpunkte eines Bildsensors einzeln zu verwenden, ist von S. Chen und R. Ginosar in "Adaptive sensitivity CCD image sensor", Proc. SPIE, Bd. 2415, SUM . 303-309 (1995) beschrieben worden. Bei dieser Technik werden jedoch alle Bildpunkte während der Bildaufnahme schnell und mehrmals wiederholt angesteuert. Diese Technik ist somit praktisch nicht bei größeren Bildsensoren mit mehreren 100.000 Bildpunkten einsetzbar.

Eine bekannte Technik, eine Offset-Ladungsmenge von einer aufintegrierten, durch Photonen erzeugten Ladungsmenge zu subtrahieren, ist die sogenannte "Fill-and-Spill"-Methode der CCD-Technologie, wie es von W. Yang in "Analog CCD processors for image filtering", Proc. SPIE, Bd. 1473, SUM. 114-127 (1991) beschrieben ist. Dabei wird ein Potentialtopf geschaffen, dessen Tiefe der Offset-Ladungsmenge entspricht. Neben diesem wird ein Potentialtopf geschaffen, dessen Tiefe der durch Photonen erzeugten Ladungsmenge entspricht und der deshalb etwas tiefer liegt. Beim Überschwemmen der Potentialtöpfe mit Ladungsträgem bleibt in dem etwas tieferen Potentialtopf eine Ladungsmenge zurück, die proportional der Differenzladungsmenge zwischen der Offset-Ladungsmenge und der Photoladung ist. Diese Technik arbeitet nur bei einer Differenzladungsmenge zuverlässig, die im Prozentbereich der Offset-Ladungsmenge liegt.

Eine andere bekannte Technik beruht auf dem Einsatz eines Strom-Speicher-Elements im Rückkopplungskreis eines Ladungsverstärkers, das heißt eines Operationsverstärkers mit einer Kapazität im Rückkopplungskreis. Dies ist von E. R. Fossum und B. Pain in "Infrared Readout Electronics for Space Science Sensors: State of the Art and Future Directions", Proc. SPIE, Bd. 2020, S. 262-285 (1993) beschrieben worden. Da der Integrationskapazität eine Stromquelle parallel geschaltet ist, ergibt sich als die effektiv integrierte Ladungsmenge die Differenz aus der durch Photonen erzeugten Ladungsmenge minus einer Offset-Ladungsmenge, welche von dieser Stromquelle geliefert wird. In dieser Veröffentlichung ist beschrieben, daß mit dieser Technik für die Infrarot-Sensortechnik ein wirksamer Ausgleich des Untergrundstroms und des Fixed Pattern Noises erreicht worden ist, dies jedoch mit erheblichem schaltungstechnischem Aufwand. Für mit kT/e verglichen kleine Spannungen über der Kapazität, das heißt für einige 10 mV, kann ein Transistor nicht mehr im Sättigungsbereich betrieben werden, und es muß daher bei dieser Technik mit Nichtlinearitäten gerechnet werden.

Der Erfindung liegt die Aufgabe zugrunde, eine photoelektrische Halbleiter-Lichterfassungseinrichtung der im Oberbegriff des Anspruches 1 genannten Gattung derart weiterzubilden, daß bei photoelektrischen Halbleiter-Lichterfas sungseinrichtungen mit hoher Dynamik der Offset-Strom programmiert werden kann.

Diese Aufgabe wird erfindungsgemäß durch die im Kennzeichen des Anspruches 1 angegebenen Merkmale gelöst.

In vorteilhafter Weise ermöglicht die Erfindung, daß die Empfindlichkeit der Halbleiter-Lichterfassungseinrichtung verringert und damit an den zu erfassenden großen dynamischen Bereich angepaßt werden kann. Dies kann, wenn mehrere Halbleiter-Lichterfassungseinrichtungen vorgesehen sind, individuell bei jeder Halbleiter-Lichterfassungseinrichtung in einer programmierbaren Weise durchgeführt werden. Die Halbleiter-Lichterfassungseinrichtung nach der Erfindung zeichnet sich durch eine große Linearität aus.

Vorteilhafte Weiterbildungen des Erfindungsgegenstandes ergeben sich aus den Unteransprüchen.

Bei der erfindungsgemäßen photoelektrischen Halbleiter-Lichterfassungseinrichtungen ist der Offset-Strom einstellbar und kann über mehr als sieben Dekaden gewählt werden kann.

Die photoelektrische Halbleiter-Lichterfassungseinrichtung nach der Erfindung besteht in der einfachsten Ausführung nur aus einer Photodiode, drei Transistoren und einer Kapazität. Damit läßt sich eine Vielzahl solcher photoelektrischer Halbleiter-Lichterfassungseinrichtungen in einfacher Weise zu ein- und zweidimensionalen Bildsensoren kombinieren. Es besteht dabei für die maximale Größe des Sensors keine grundsätzliche Grenze. Die minimale Fläche der Offset-Photodioden-Bildpunkte ist nur unwesentlich größer als herkömmliche, nicht Offset-programmierbare Photodioden-Bildpunkte. Damit steht ein sehr wirksames Mittel zur Verfügung, um Nicht-Uniformitäten der einzelnen Bildpunkte untereinander auszugleichen und die Dynamik des Bildsensors programmierbar und problemangepaßt auf das Vielfache der bekannten Werte zu vergrößern.

Gemäß einer Ausführungsform der Erfindung folgt der beschriebenen Anordnung aus Photodiode und programmierbarer Offset-Stromquelle eine bekannte Auswertungseinrichtung zur Analyse von periodischen Signalen. In dieser ersetzt die Erfindung die bekannte Wechselstromkopplung von Signalen, die eine geringe Modulationstiefe, d.h. Modulationsamplitude, aufweisen, indem ein großer Teil des Untergrundsignals subtrahiert werden kann. In dieser Form findet die Erfindung überall dort in der optischen Meßtechnik Verwendung, wo periodische. schwingende Vorgänge analysiert werden sollen, und Signale mit sehr kleiner Modulationstiefe auftreten. In diesen Fällen kann mit der Erfindung eine bedeutend größere elektrische Modulationstiefe erreicht werden. Beispiele für solche Anwendungen umfassen alle Meßprinzipien, denen der Einsatz von gepulsten, d. h. zeitlich modulierten Lichtquellen, zugrunde liegt. Ein Beispiel hierfür sind Laufzeitmessungen zur optischen Entfernungsmessung.

Die Erfindung ermöglicht auch das Erfassen von ein- und zweidimensionalen, zeitlich wechselnden Bilddaten hoher Dynamik. Dabei wird zeitlich und örtlich durch geeignete Wahl und Programmierung der Offset-Ströme die Dynamik der Signale reduziert, damit nur noch viele kleine Ladungs-Differenzen gemessen werden müssen. Typische Anwendungen bieten sich in der elektronischen Photografie, der Videotechnik und der optischen Meßtechnik, wo hohe Dynamik und hohe Untergrundsignale auftreten.

Die Erfindung kann auf allen Gebieten vorteilhaft eingesetzt werden, wo elektromagnetische Strahlung mit Hilfe von photoelektrischen Halbleiter-Lichterfassungseinrichtungen erfaßt werden soll und ein hoher dynamischer Bereich verlangt wird. Unter dynamischem Bereich wird in diesem Zusammenhang das Verhältnis der maximal erfassbaren zu minimal detektierbaren Strahlung bezeichnet.

Insbesondere können photoelektrische Halbleiter-Lichterfassungseinrichtungen nach der Erfindung zu einer ein- und zweidimensionalen Vielfachanordnung aufgebaut werden, wodurch ein Zeilen- oder Bildsensor mit extrem hohem dynamischem Bereich entsteht. Die einzelnen photoelektrischen Halbleiter-Erfassungseinrichtungen können individuell programmiert werden.

Eine weitere vorteilhafte Anwendung der Erfindung betrifft die Erfassung von Bilddaten im sichtbaren und nahen Infrarot-Spektralbereich wie für die Videotechnik. Es ist bekannt, daß Bilddaten von natürlichen Szenen eine sehr große Dynamik aufweisen.

Ein weiterer Anwendungsbereich für die Erfindung ist die Infrarot-Sensorik, wobei die Bilddaten häufig von einem großen Untergrundsignal überlagert sind, und die primären Meßdaten letztlich nur die Differenz zu diesem Untergrund aufgrund von lokalen Temperaturdifferenzen sind.

Ein anderes Anwendungsgebiet für die Erfindung ist die optische Meßtechnik, bei der modulierte Lichtverteilungen auftreten, die von einem großen Untergrund überlagert sind, der für das Meßproblem uninteressant und nur störend ist.

Ferner ist die Erfindung zur Verbesserung von Signalen mit photoelektrischen Lichterfassungselementen einsetzbar, die aufgrund des Erfassungsprinzips oder von Mängeln bei der Herstellung einen großen Untergrund aufweisen (z. B. Offset-Strom oder kleine Leck-Widerstand), der für die Messung störend ist.

Ein weiters Anwendungsgebiet betrifft Meßprinzipien, die auf dem Erfassen von diffus rückgestreutem Licht an Objekten beruht, die sich innerhalb weiter Grenzen des Abstandes im variablen Umgebungslicht befinden. Da die Intensität des rückgestreuten Lichtes näherungsweise quadratisch mit dem Abstand des Objektes abnimmt, das Untergrundlicht aber in erster Näherung kurzzeitig unverändert bleibt, kann die Erfindung zum Ausgleich des Umgebungslichts eingesetzt werden, wobei die Dynamik der Signallicht-Erfassung wesentlich erhöht werden kann.

Der Erfindungsgegenstand wird im folgenden an Hand von Ausführungsformen unter Bezugnahme auf die Zeichnungen näher erläutert. Es zeigt:
- Fig. 1: eine erste Ausführungsform der Erfindung;
- Fig. 2: eine mögliche Signalausleseform der Erfindung, und
- Fig. 3: den Verlauf des Stroms durch den ersten MOS-Feldeffekttransistors als Funktion seiner Gate-Spannung

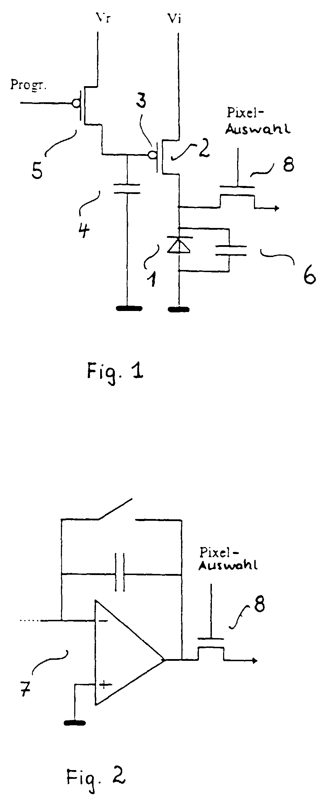

Bei der in Fig. 1 dargestellten Ausführungsform weist eine photoelektrische Halbleiter-Lichterfassungseinrichtung ein Halbleiter-Photoelement in der Form einer Photodiode 1 auf, die eine einfallende Lichtintensität in eine proportionale Photostromdichte umwandelt. Diese Photostromdichte ist, wie es auf diesem Gebiet der Technik bekannt ist, über 8 bis 10 Dekaden streng linear zu der einfallenden Lichtintensität. Die Kathode der Photodiode 1 ist mit der Drain eines MOS-Feldeffekt-Transistors 2 verbunden. An diesem MOS-Feldeffekttransistor ist zwischen der Source und der Drain eine Spannung Vᵢ angelegt, welche deutlich größer als kT/e ist, wobei k die Boltzmannkonstante, T die absolute Temperatur und e die Elementarladung bezeichnet. Der MOS-Feldeffekttransistor wird damit in einem Zustand betrieben, der als Sättigung bezeichnet wird (vgl. C. A. Mead, "Analog VLSI and Neural Systems", Addison, Wesley, Reading (1989)). Dabei hängt der Strom durch den MOS-Feldeffekttransistor beinahe nicht mehr von der Spannungsdifferenz zwischen Source und Drain ab, sondern nur noch von der Gate-Source-Spannung. Die geringfügige Abweichung vom idealen Verhalten dieser Stromquelle, wird in der Literatur als Early-Effekt bezeichnet, ist für die Arbeitsweise dieser Ausführungsform nach der Erfindung von untergeordneter Bedeutung, da die Spannungsänderung an der Drain des MOS-Feldeffekttransistors im Fall einer Photodiode als Halbleiter-Photoelement nur logarithmisch mit der Lichtintensität zunimmt.

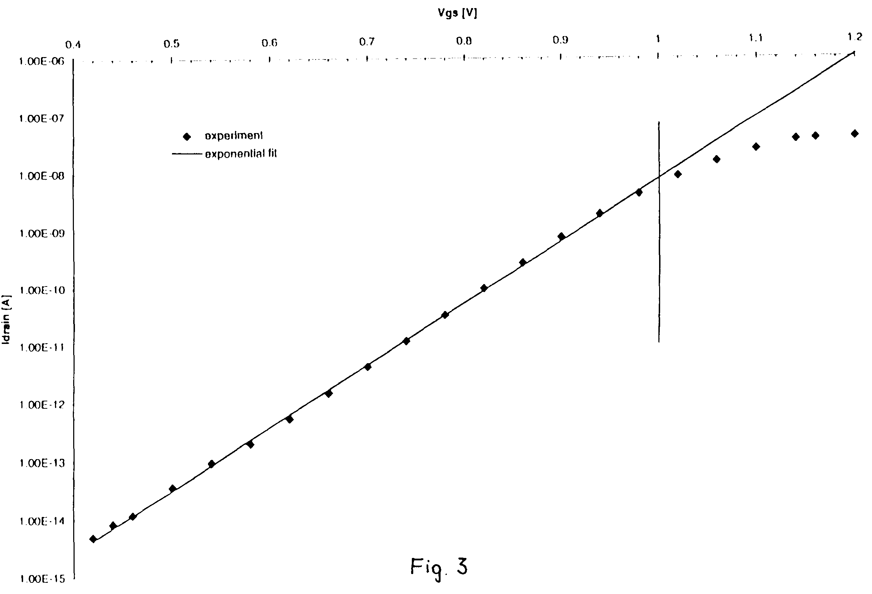

Wird an das Gate 3 dieses MOS-Feldefeffekttransistors 2 eine Spannung angelegt, so fließt bei einer Gate-Spannung von bis zu einigen 100 Millivolt ein Strom, der exponential von der Gate-Spannung abhängt. Dieser Bereich wird als Subthreshold-Region bezeichnet. Bei einer typischen Spannung von etwas unter einem Volt flacht die Strom-Spannungskennlinie ab, und die Stromzunahme hängt nur noch quadratisch von der Gate-Spannung ab. Damit steht eine programmierbare Stromquelle zur Verfügung, mit der für den entsprechenden Bildpunkt ein Offset-Strom im Bereich von fA bis Mikroampere oder größer über die Gate-Spannung eingestellt werden kann. Diesbezüglich wird auf die Fig. 3 verwiesen.

Statt der dargestellten Ausführung mit einer Photodiode 1 in Kombination mit einem p-Kanal-MOS-Feldeffekttransistor an der Kathode der Photodiode 1 könnte auch alternativ ein n-Kanal-MOS Feldeffekttransistor mit der Anode der Photodiode 1 mit sinngemäßer Wahl der Spannungen ausgeführt werden.

Die an dem Gate 3 benötigte Spannung kann auf zwei Arten gespeichert werden. Eine Möglichkeit besteht in einer Speicherkapazität 4, die jeweils über einen Programmier-MOS-Feldeffekttransistor 5 an eine Spannungsquelle Vᵣ angeschlossen werden kann. Eine andere Möglichkeit, bei der der programmierte Spannungswert über einen längeren Zeitraum bewahrt werden kann, besteht darin, das Gate 3 als ein sogenanntes Floating-Gate auszubilden, auf das durch Tunnelströme analoge Ladungsmengen aufgebracht werden können.

Dieses Prinzip ist aus der Technik der elektrisch programmierbaren Speicherbausteine (EEPROMs) bekannt (vgl. US Patent No. 05336936 von T. P. Allen and J. B. Cser mit dem Titel "One-transistor adaptable analog storage element and array", das am 09. August 1994 erteilt wurde). Bei der Verwendung dieser Technik wird die Ansteuerung über einen Programmier-MOS-Feldeffekttransistor 5 vorgenommen, der jedoch keinen direkt leitenden Kontakt mit dem Gate 3 mehr hat, sondern nur noch über ein dünnes Gate-Oxid mit dem Gate 3 verbunden ist.

Die für den Bildpunkt individuelle Ansteuerung der Speicherkapazität zum Auslesen erfolgt mittels des dritten MOS-Feldeffekttransistors 8, in dem dessen Gate entsprechend angesteuert wird. Dies kann gleichzeitig durchgeführt werden oder auch zeitlich aufeinanderfolgend. Auf diese Weise kann jede Stromquelle der einzelnen Bildelemente (Pixel) mit einem eigenen Offset-Strom programmiert werden.

Am Ausgang der Photodiode steht damit ein Signalstrom zur Verfügung, der gleich der Differenz zwischen dem Photostrom und dem individuell programmierten Offset-Strom ist. Dieser Signalstrom kann mit bekannten Techniken zum gewünschten Signal integriert werden. Im einfachsten Fall wird hierfür die Sperrschicht-Kapazität (6) der (rückwärts vorgespannten) Photodiode 1 verwendet.

Es kann aber auch, wie es beschrieben worden ist, gemäß Fig. 2 ein rücksetzbarer Ladungsintegrator 7 verwendet werden. wodurch sich der Vorteil ergibt, daß die Empfindlichkeit gegenüber kleinen Parallelwiderständen der photoelektnschen Lichterfassungseinrichtung verringert wird, wie sie bei photoelektrischen Lichterfassungseinrichtungen im längeren Wellenlängenbereich bekanntermaßen auftreten. Weitere bekannte Ausführungsformen zur Integration des Differenzstroms, wie sie aus dem Stand der Technik bekannt sind, sind beispielsweise in der bereits genannten Druckschrift von E. R. Fossum und B. Pain beschrieben.

Das Auslesen und Rückstellen der Integrationskapazität bzw. Integrationskapazitäten erfolgt mit einem bekannten Auslesetransistor 8, welcher periodisch eine Auslese-Leitung mit den einzelnen Bildpunkten verbindet. Mittels dieser Ausleseleitung kann die Signalladung abfließen und sie wird mit bekannten Erfassungsschaltungen nachgewiesen. Alternativ kann eine erste Impedanzwandlung des Ladungssignals auch am Ort des Bildpunktes mit bekannten Techniken stattfinden, die auf dem Gebiet von Active-Pixel-Sensors (APS) eingesetzt werden. Damit kann auch eine Verringerung des Ausgangs-Rauschpegels erreicht werden.

## Patentansprüche

1. Photoelektrische Halbleiter-Lichterfassungseinrichtung mit hoher Dynamik durch programmierbares Offset-Signal, die ein Halbleiter-Photoelement aufweist, durch das darauf auftreffende Lichtintensität in einen proportionalen Photostrom umwandelbar ist,
**gekennzeichnet, durch**
einen ersten, in Sättigung betriebenen MOS-Feldeffekttransistor (2) des entsprechenden Kanal-Typs, dessen Drain mit dem Halbleiter-Photoelement (1) gekoppelt ist und dessen Source auf einem konstanten Potential Vᵢ gehalten ist,
einen zweiten MOS-Feldeffekttransistor (5), durch den eine vorbestimmte, veränderbare Ladungsmenge auf das Gate des ersten MOS-Feldtransistors (2) aufbringbar ist,
eine an dem Gate (3) des ersten MOS-Feldeffekttransistors (2) vorgesehene Kapazität (4),
eine Integrationseinrichtung. mit der die Differenz aus Offset-Strom und Photostrom integrierbar ist,
einen als Schalter betreibbaren, dritten MOS-Feldeffekttransistor (8), mit dem die Integrationseinrichtung ausgelesbar und wieder auf einen bestimmten Wert zurücksetzbar ist.

2. Einrichtung nach Anspruch 1, **dadurch gekennzeichnet**, daß das Halbleiter-Photoelement eine Photodiode (1) ist, deren Kathode bzw. Anode in Abhängigkeit von dem Kanal-Typ des ersten MOS-Feldeffekt-transistors mit dessen Drain verbunden ist.

3. Einrichtung nach Anspruch 1 oder 2, **dadurch gekennzeichnet**, daß die an dem Gate (3) des ersten MOS-Feldeffekttransistors (2) vorgesehene Kapazität (4) als eine integrierte Kapazität mit unmittelbarer Verbindung mit dem zweiten MOS-Feldeffekttransistor (5) ausgebildet ist.

4. Einrichtung nach Anspruch 1 oder 2, **dadurch gekennzeichnet**, daß die an dem Gate (3) des ersten MOS-Feldeffekttransistors (2) vorgesehene Kapazität (4) als eine Floating-Gate-Kapazität ohne unmittelbare, leitende Verbindung mit dem zweiten MOS-Feldeffekttransistor (5) ausgebildet ist.

5. Einrichtung nach Anspruch 2, **dadurch gekennzeichnet**, daß der Differenzstrom auf der Sperrschichtkapazität der Photodiode (1) oder einem Ladungsintegrator (7) aufintegriert wird.

6. Bildsensoreinrichtung, **dadurch gekennzeichnet**, daß die Bildsensoreinrichtung aus einer ein- oder zweidimensionalen Vielfachanordnung photoelektrischer Halbleiter-Lichterfassungseinrichtungen nach einem der vorhergehenden Ansprüche aufgebaut ist.

7. Bildsensor nach Anspruch 6, **dadurch gekennzeichnet**, daß eine Einrichtung vorgesehen ist, mit der jede photoelektrische Halbleiter-Lichterfassungseinrichtung einzeln, mit veränderbarer Geschwindigkeit mit einem Offset-Strom programmierbar ist, der bei der Lichterfassung subtrahiert wird.

8. Bildsensor nach Anspruch 6, **dadurch gekennzeichnet**, daß alle photoelektrischen Halbleiter-Lichterfassungseinrichtungen mit dem gleichen Offset-Strom programmierbar sind.

## Claims

1. Photoelectric semiconductor light-detection device with high dynamics through a programmable offset signal, which comprises a semiconductor photoelement by which light intensities incident thereon can be converted into a proportional photoelectric current, characterised by a first MOS field effect transistor (2), which is operated in saturation, of the corresponding channel-type, the drain of which is coupled with the semiconductor photoelement (1) and the source of which is kept at a constant potential Vᵢ, a second MOS field effect transistor (5), by which a predetermined, variable charging amount can be applied to the gate of the first MOS field transistor (2), a capacitor (4) provided at the gate (3) of the first MOS field effect transistor (2), an integrating device by which the difference between offset current and photoelectric current can be integrated, and a third MOS field effect transistor (8), which is operable as a switch and by which the integrating device can be read out and reset back to a specific value.

2. Device according to claim 1, characterised in that the semiconductor photoelement is a photodiode (1), the cathode or anode of which is connected with the drain of the first MOS field effect transistor in dependence on the channel-type thereof.

3. Device according to claim 1 or 2, characterised in that the capacitor (4) provided at the gate (3) of the first MOS field effect transistor (2) is formed as an integrated capacitor with direct connection with the second MOS field effect transistor (5).

4. Device according to claim 1 or 2, characterised in that the capacitor (4) provided at the gate (3) of the first MOS field effect transistor (2) is formed as a floating-gate capacitor without direct, conductive connection with the second MOS field effect transistor (5).

5. Device according to claim 2, characterised in that the difference current is integrated up to the blocking layer capacitance of the photodiode (1) or a charging integrator (7).

6. Image sensor device, characterised in that the image sensor device is built up from a one-dimensional or two-dimensional multiple arrangement of photoelectric semiconductor light-detection devices according to one of the preceding claims.

7. Image sensor according to claim 6, characterised in that a device is provided by which each photoelectric semiconductor light-detection device is programmable at variable speed by an offset current, which is subtracted in the case of light detection.

8. Image sensor according to claim 6, characterised in that all photoelectric semiconductor light-detection devices are programmable by the same offset current.

## Revendications

1. Dispositif de détection de lumière photo-électrique à semi-conducteur avec haute dynamique par un signal programmable de décalage, qui présente un élément photo-électrique à semi-conducteur par lequel la densité de lumière qui s'y présente peut être convertie en un courant photo-électrique proportionnel
caractérisé par
un premier transistor à effet de champ MOS (2) fonctionnant à la saturation, du type de canal correspondant, dont le drain est couplé à l'élément photo-électrique à semi-conducteur (1) et dont la source est maintenue à un potentiel V constant,
un second transistor à effet de champ MOS (5) par lequel une quantité de charge prédéterminée, modifiable, peut être appliquée à la porte du premier transistor à effet de champ MOS (2),
une capacité (4) prévue à la porte (3) du premier transistor à effet de champ MOS (2),
un dispositif d'intégration, par lequel peut être intégrée la différence du courant de décalage et du courant photo-électrique,
un troisième transistor à effet de champ MOS (8) pouvant fonctionner comme un commutateur, par lequel le dispositif d'intégration peut être lu et remis à une valeur déterminée.

2. Dispositif selon la revendication 1, caractérisé en ce que l'élément photo-électrique à semi-conducteur est une photodiode (1), dont la cathode ou respectivement l'anode est reliée, selon le type de canal du premier transistor à effet de champ MOS, à son drain.

3. Dispositif selon la revendication 1 ou 2, caractérisé en ce que la capacité (4) prévue à la porte (3) du premier transistor à effet de champ MOS (2) est configurée comme une capacité intégrée avec liaison directe au deuxième transistor à effet de champ MOS (5).

4. Dispositif selon la revendication 1 ou 2, caractérisé en ce que la capacité (4) prévue à la porte (3) du premier transistor à effet de champ MOS (2) est configurée en une capacité à porte flottante sans liaison conductrice directe avec le deuxième transistor à effet de champ MOS (5).

5. Dispositif selon la revendication 2, caractérisé en ce que le courant de différence peut être intégré sur la capacité de la couche de blocage de la photodiode électrique (1) ou bien sur un intégrateur de charge (7).

6. Dispositif capteur d'image caractérisé en ce que le dispositif capteur d'image est formé d'un agencement multiple uni ou bidimensionnel de dispositifs photo-électrique de détection de la lumière à semi-conducteur selon l'une des revendications précédentes.

7. Capteur d'image selon la revendication 6, caractérisé en ce qu'un dispositif est prévu par lequel chaque dispositif de détection de lumière photo-électrique à semi-conducteur peut être programmé individuellement à une vitesse modifiable au moyen d'un courant de décalage qui est soustrait lors de la détection de la lumière.

8. Capteur d'image selon la revendication 6, caractérisé en ce que tous les dispositifs de détection de lumière photo-électriques à semi-conducteur sont programmables au moyen du même courant de décalage.
